Europäisches Patentamt

European Patent Office

Office européen des brevets

(19)

(11) Numéro de publication: **0 249 929 B1**

(12) **FASCICULE DE BREVET EUROPEEN**

(45) Date de publication de fascicule du brevet:
**16.10.91**

(51) Int. Cl.⁵: **H03L 7/00, H04L 1/24**

(21) Numéro de dépôt: **87108623.7**

(22) Date de dépôt: **16.06.87**

(54) **Dispositif de stabilisation du rythme d'apparition d'impulsions.**

(30) Priorité: **19.06.86 FR 8608859**

(43) Date de publication de la demande:
**23.12.87 Bulletin 87/52**

(45) Mention de la délivrance du brevet:
**16.10.91 Bulletin 91/42**

(84) Etats contractants désignés:
**BE DE FR GB IT NL SE**

(56) Documents cités:
**US-A- 3 164 777**

**IBM TECHNICAL DISCLOSURE BULLETIN, vol. 23, no. 1, juin 1980, pages 81-82, New York, US; M.L. CARNES et al.: "Cycle-synchronized phase-locked loop"**

(73) Titulaire: **ALCATEL CIT**
**12 Rue de la Baume**
**F-75008 Paris(FR)**

(72) Inventeur: **Paul, Philippe**
**Kastel Kerguiniou Ploubezre**
**F-22300 Lannion(FR)**

(74) Mandataire: **Weinmiller, Jürgen et al**
**Lennéstrasse 9 Postfach 24**
**W-8133 Feldafing(DE)**

## Description

La présente invention est du domaine de l'électronique et concerne notamment le comptage des erreurs détectées sur une ligne de transmission numérique en vue d'établir le taux d'erreurs de transmission.

La surveillance de la qualité de transmission d'une liaison numérique se fait par la mesure du taux d'erreurs c'est-à-dire du nombre d'erreurs mises en évidence par des violations du code en ligne par rapport au nombre d'éléments binaires transmis. Les violations du code en ligne, normalement très espacées, peuvent apparaître par paquets ; elles sont signalées par des impulsions de très courte durée de l'ordre de grandeur de la durée d'un élément binaire (quelques 10 ns à 1 ns ou moins) dont il faut assurer périodiquement le comptage.

Dans la pratique, ce comptage est effectué par des circuits à microprocesseur qui sont adaptés au rythme moyen d'apparition des erreurs correspondant au taux maximal d'erreurs que l'on veut pouvoir mesurer mais qui sont trop lents pour réagir aux très courtes durées des impulsions et que l'on fait précéder par des circuits d'élargissement d'impulsions ayant l'inconvénient de réunir des impulsions se produisant dans une durée inférieure à celle de l'élargissement et, par conséquent, de ne voir qu'une seule erreur lorsque plusieurs se produisent de manière très rapprochée.

La présente invention a pour but de remplacer les circuits d'élargissement d'impulsions par un dispositif n'en présentant pas l'inconvénient précité et n'utilisant qu'un minimum de circuits à technologie rapide pour diminuer le coût et la puissance consommée.

L'invention a pour objet un dispositif de stabilisation du rythme d'apparition d'impulsions asynchrones à base de deux compteurs, l'un tournant au rythme irrégulier d'apparition des impulsions asynchrones l'autre à rythme régulier au moins égal au rythme moyen admissible pour les impulsions asynchrones associé à un circuit logique de poursuite. Ce dispositif comporte :

- un premier compteur d'impulsions de type asynchrone pourvu d'une entrée de comptage recevant les impulsions asynchrones, d'une entrée de blocage, de sorties parallèles et de premiers étages à vitesse de fonctionnement compatible avec la fréquence maximale de succession des impulsions asynchrones,
- un oscillateur pourvu d'une entrée de blocage, délivrant en sortie des impulsions à un rythme stabilisé,
- un deuxième compteur d'impulsions pourvu d'une entrée de comptage recevant les impulsions de l'oscillateur et de sorties parallèles,
- un comparateur avec des entrées de comparaison connectées aux sorties de même poids des deux compteurs et avec une sortie de détection d'égalité connectée à l'entrée de blocage de l'oscillateur, ledit comparateur bloquant l'oscillateur en cas d'égalité des comptes des deux compteurs et
- un circuit logique de contrôle d'antirattrapage qui est piloté par des sorties des deux compteurs et agit sur l'entrée de blocage du premier compteur de manière à bloquer celui-ci lorsqu'il risque de rattraper le deuxième compteur.

Selon un mode de réalisation préféré, les deux compteurs ont une capacité égale à $2^N-1$, N étant un entier plus grand que un et le circuit logique de contrôle d'antirattrapage comporte une première bascule maintenue au repos par un état logique 1 sur la sortie de poids $2^{N-1}$ du deuxième compteur et déclenchée par une transition du niveau logique 1 au niveau logique 0 sur la sortie de poids $2^{N-1}$ du premier compteur pour engendrer un ordre de blocage de ce dernier, et une deuxième bascule maintenue au repos par un état logique 0 sur la sortie de poids $2^{N-1}$ du deuxième compteur et déclenchée par une transition du niveau logique 0 au niveau logique 1 sur la sortie de poids $2^{N-1}$ du premier compteur pour engendrer un ordre de blocage de ce dernier.

D'autres caractéristiques et avantages de l'invention ressortiront de la description ci-après d'un mode de réalisation donné à titre d'exemple. Cette description sera faite en regard du dessin qui comporte ;

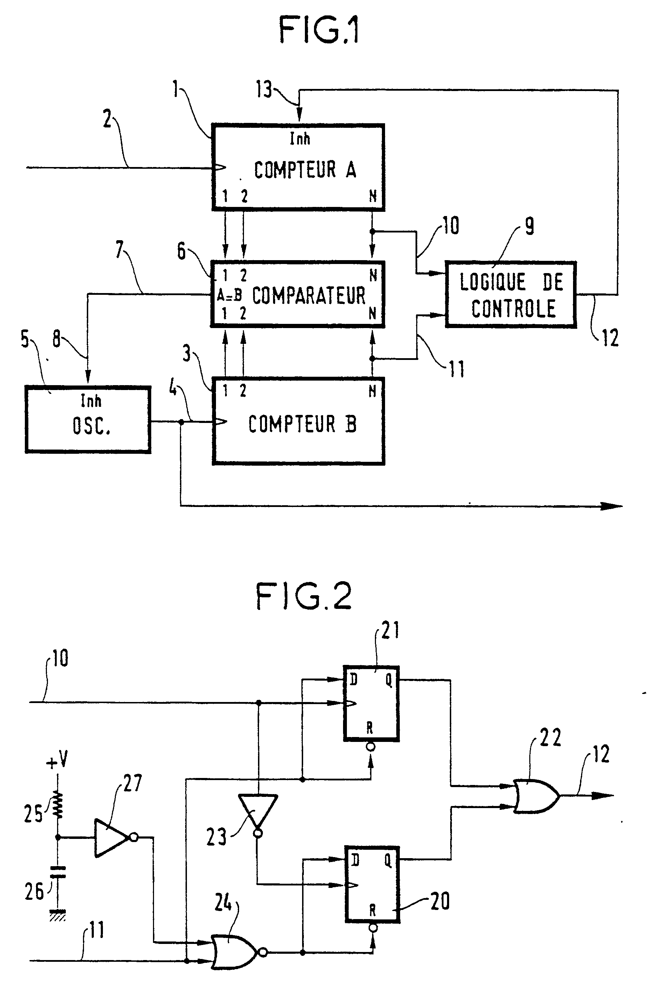

- une figure 1 représentant de manière schématique un dispositif selon l'invention et
- une figure 2 détaillant un circuit logique d'antirattrapage apparaissant à la figure 1.

Le dispositif représenté à la figure 1 comporte un premier compteur A indexé par le chiffre 1 recevant sur son entrée de comptage 2 une suite d'impulsions asynchrones dont on veut stabiliser le rythme, un deuxième compteur B indexé par le chiffre 3 recevant sur son entrée de comptage 4 les impulsions de sortie d'un oscillateur 5 fonctionnant au rythme stabilisé choisi, au moins égal au rythme moyenne admissible pour les apparitions des impulsions asynchrones, un comparateur 6 connecté par ses entrées aux sorties 1, 2,... N de même poids des compteurs A et B et par sa sortie 7 de détection d'égalité à une entrée d'inhibition 8 de l'oscillateur 5, et un circuit logique de contrôle d'antirattrapage avec ses entrées 10 et 11 connectées aux sorties de plus fort poids des compteurs A et B et sa sortie 12 connectée à une entrée d'inhibition 13 du compteur A.

Le premier compteur A est de type asynchrone. Seuls ses premiers étages qui doivent avoir une vitesse de fonctionnement compatible avec la fréquence maximale de succession des impulsions asynchrones sont éventuellement en technologie rapide. Il est de capacité $2^N$-1 , N étant un entier supérieur à un, et s'incrémente au rythme irrégulier des apparitions des impulsions asynchrones. A la mise sous tension, il est initialisé à zéro par une commande non illustrée.

Le deuxième compteur B, de même capacité $2^N$-1 que le premier compteur A s'incrémente de manière régulière au rythme de l'oscillateur 5 à la poursuite de la valeur du compteur A sans la dépasser car l'oscillateur 5 est bloqué par le comparateur 6 à chaque fois que celui-ci détecte l'égalité des valeurs de comptage des deux compteurs. A la mise sous tension, il est également initialisé à zéro par une commande non illustrée.

Le circuit logique de contrôle intervient en cas de saturation du dispositif lorsque le premier compteur A tend à rattraper le deuxième compteur B. Un tel rattrapage serait provoqué par un nombre d'impulsions asynchrones excédant de $2^N$ ou d'un multiple de $2^N$ celui des impulsions fournies par l'oscillateur 5. Si on laissait survenir de tels rattrapages, il se produirait à chacun d'eux une erreur brutale de $2^N$ sur le nombre d'impulsions restituées en sortie du dispositif. Pour éviter cet inconvénient, le circuit logique de contrôle provoque un blocage temporaire du premier compteur A dès que celui-ci a tendance à rejoindre de trop près le deuxième compteur B ce qui sert d'alarme de saturation et ne provoque qu'une erreur progressive sur le nombre d'impulsions restituées cessant d'augmenter dès que le phénomène de saturation disparaît.

Un exemple de réalisation de ce circuit logique de contrôle est représenté à la figure 2. Prévu pour un premier compteur A à commande d'inhibition active au niveau logique 1, il engendre un ordre de blocage du premier compteur A soit lorsque celui-ci atteint 0 modulo $2^N$ alors que le deuxième compteur B est dans un état de comptage compris entre 0 et $2^{N-1}$-1 modulo $2^N$ soit lorsque ce compteur atteint $2^{N-1}$ modulo $2^N$ alors que le deuxième compteur B est dans un état de comptage compris entre $2^{N-1}$ et $2^N$-1 modulo $2^N$. Pour ce faire il comporte deux bascules de type D 20 et 21 dont les sorties Q sont couplées à la sortie 12 du circuit logique de contrôle par une porte logique de type "ou" 22.

Ces deux bascules de type D ont une entrée d'horloge sensible aux fronts montants et une entrée complémentée de remise à zéro. La première 20 a son entrée d'horloge connectée par l'intermédiaire d'un inverseur 23 et de l'entrée 10 du circuit logique de contrôle à la sortie de poids $2^{N-1}$ du premier compteur A, et ses entrées D et de remise à zéro connectées par l'intermédiaire d'une porte logique de type "non ou" 24 et de l'entrée 11 du circuit logique de contrôle à la sortie de poids $2^{N-1}$ du deuxième compteur B. La deuxième bascule 21 a son entrée d'horloge connectée par l'entrée 10 du circuit logique de contrôle à la sortie de poids $2^{N-1}$ du premier compteur A et ses entrées D et de remise à zéro connectées par l'entrées 11 du circuit logique à la sortie de poids $2^{N-1}$ du deuxième compteur B.

Lorsque la sortie de poids $2^{N-1}$ du compteur B est au niveau logique 0, le deuxième compteur B renferme un compte compris dans la première moitié de sa capacité ; la deuxième bascule 21 est bloquée et la première bascule 20 active peut être déclenchée à tout instant par le passage du niveau logique 1 au niveau logique 0 de la sortie de poids $2^{N-1}$ du premier compteur A c'est-à-dire par tout dépassement de capacité de ce premier compteur A.

Lorsque la sortie de poids $2^{N-1}$ du compteur B est au niveau logique 1, le deuxième compteur B renferme un compte compris dans la deuxième moitié de sa capacité ; la première bascule 20 est bloquée et la deuxième bascule 21 active peut être déclenchée à tout instant par le passage du niveau logique 0 au niveau logique 1 de la sortie de poids $2^{N-1}$ du premier compteur A c'est-à-dire par tout dépassement de celui-ci de sa demi-capacité.

Autrement dit, la première bascule 20 engendre un ordre de blocage du premier compteur A lorsque celui-ci atteint 0 modulo $2^N$ alors que le deuxième compteur B est à la première moitié de sa capacité, son compte étant compris entre 0 et $2^{N-1}$-1 modulo $2^N$, et maintient cet ordre jusqu'à ce que le compteur B atteigne $2^{N-1}$ modulo $2^N$ ce qui en provoque la suppression ; la deuxième bascule 21 engendre un ordre de blocage du compteur A lorsque celui-ci atteint $2^{N-1}$ modulo $2^N$ alors que le deuxième compteur B est dans la deuxième moitié de sa capacité, son compte étant compris entre $2^{N-1}$ et $2^N$-1 modulo $2^N$, et maintient cet ordre jusqu'à ce que le compteur B atteigne 0 modulo $2^N$ ce qui en provoque la suppression.

La porte logique de type "non ou" 24 dont on a singalé uniquement la fonction inverseuse qu'elle remplit par rapport à l'entrée 11 lorsque le dispositif est en fonctionnement permet par sa deuxième entrée le démarrage du circuit logique à la mise sous tension. En effet, elle est connectée par cette deuxième entrée à un circuit de mise sous tension formé d'un circuit série RC 25, 26 et d'un amplificateur inverseur 27 provoquant la remise à zéro de la première bascule 20, celle de la deuxième bascule 21 résultant du niveau logique 0 présent sur la sortie de poids $2^{N-1}$ du deuxième compteur B initialisé à zéro à la mise sous tension.

On notera que l'initialisation des compteurs A et B à la mise sous tension est assurée également par ce circuit de mise sous tension à l'aide du signal de sortie de l'amplificateur inverseur 27 appliqué, par des liaisons non représentées, à des entrées de remise à zéro de ces compteurs.

Le dimensionnement du dispositif c'est-à-dire la capacité à donner aux compteurs et la fréquence à choisir pour l'oscillateur dépend des conditions d'utilisation. Dans le cas mentionné en préambule du comptage des erreurs détectées en ligne sur une voie de transmission numérique, il est demandé par exemple de pouvoir compter les erreurs détectées en une seconde jusqu'à un taux de $10^{-3}$ au moins, c'est-à-dire $10^{-3}$ fois le débit en ligne. Il suffira donc d'adopter pour la valeur de la fréquence de l'oscillateur $10^{-3}$ fois la valeur de ce débit et pour la capacité des compteurs le nombre de cycles en une seconde de l'oscillateur et le dispositif de stabilisation de rythme permettra de multiplier par 1000 la durée des impulsions de signalisation d'erreurs les rendant compatibles avec les vitesses de traitement par microprocesseur. Ainsi, dans le cas d'un système numérique classique à 140 Mbit/s codé en 5B/6B où le débit en ligne est de 168 Mbit/s, on pourra choisir des compteurs de capacité de l'ordre de $2^{18}$ et une fréquence de l'oscillateur de 168 kHz beaucoup plus accessible pour un système à microprocesseur que la fréquence de 168 MHz à laquelle peuvent se succéder les signalisations d'erreurs.

On peut, sans sortir du cadre de l'invention modifier certaines dispositions ou remplacer certains moyens par des moyens équivalents.

## Revendications

1. Dispositif de stabilisation du rythme d'apparition d'impulsions asynchrones, caractérisé en ce qu'il comporte :
   - un premier compteur d'impulsions (1), de type asynchrone pourvu d'une entrée de comptage (2) recevant les impulsions asynchrones, d'une entrée de blocage (13), de sorties parallèles et de premiers étages à vitesse de fonctionnement compatible avec la fréquence maximale de succession des impulsions asynchrones,
   - un oscillateur (5) pourvu d'une entrée de blocage (8) et délivrant en sortie des impulsions au rythme stabilisé,
   - un deuxième compteur d'impulsions (3) pourvu d'une entrée de comptage (4) recevant les impulsions de l'oscillateur (5) et de sorties parallèles,
   - un comparateur (6) avec des entrées de comparaison connectées aux sorties de mêmes poids des deux compteurs (1, 3) et avec une sortie de détection d'égalité (7) connectée à l'entrée de blocage (8) de l'oscillateur, ledit comparateur (6) bloquant l'oscillateur (5) en cas d'égalité des comptes des deux compteurs (1, 3) et
   - un circuit logique de contrôle d'antirattrapage (9) qui est piloté par des sorties des deux compteurs (1, 3) et agit sur l'entrée de blocage (13) du premier compteur (1) de manière à bloquer celui-ci lorsqu'il risque de rattraper le deuxième compteur (3).

2. Dispositif selon la revendication 1 avec deux compteurs de capacité au moins égale à $2^N-1$, N étant un entier plus grand que un, caractérisé en ce que le circuit logique de contrôle d'antirattrapage comporte des premiers moyens pour engendrer un ordre de blocage du premier compteur lorsque celui-ci atteint 0 modulo $2^N$ alors que le deuxième compteur est dans un état de comptage compris entre 0 et $2^{N-1}-1$ modulo $2^N$ et pour ne faire cesser cet ordre que lorsque le deuxième compteur atteint $2^{N-1}$ modulo $2^N$, et des deuxièmes moyens pour engendrer un ordre de blocage du premier compteur lorsque celui-ci atteint $2^{N-1}$ modulo $2^N$ alors que le deuxième compteur est dans un état de comptage compris entre $2^{N-1}$ et $2^{N-1}-1$ modulo $2^N$ et pour ne faire cesser cet ordre que lorsque le deuxième compteur atteint 0 modulo $2^N$.

3. Dispositif selon la revendication 2, caractérisé en ce que lesdits premiers moyens comportent une première bascule (20) maintenue au repos par un état logique 1 sur la sortie de poids $2^{N-1}$ du deuxième compteur (3) et déclenchée par une transition du niveau logique 1 au niveau logique 0 de la sortie de poids $2^{N-1}$ du premier compteur (1) et en ce que lesdits deuxièmes moyens comportent une deuxième bascule (21) maintenue au repos par un état logique 0 sur la sortie de poids $2^{N-1}$ du deuxième compteur (3) et déclenchée par une transition du niveau logique 0 au niveau logique 1 de la sortie de poids $2^{N-1}$ du premier compteur (1).

## Claims

1. A circuit for stabilizing the rate at which asynchronous pulses appear, the circuit being characterized in that it comprises:
   a first pulse counter (1) of the asynchronous type provided with a count input (2) receiving the asynchronous pulses, an inhibit input (13), and parallel outputs, and having initial stages with an operating speed compatible with the maximum frequency at which the asynchronous pulses succeed one another;

an oscillator (5) having an inhibit input (8) and delivering output pulses at a stable rate;

a second pulse counter (3) provided with parallel outputs and with a count input (4) receiving pulses from the oscillator (5);

a comparator (6) having comparison inputs connected to outputs of equal significance from the two counters (1, 3) and having an equality detection output (7) connected to the inhibit input (8) of the oscillator, said comparator (6) inhibiting the oscillator (5) in the event of the counts in the two counters (1, 3) being equal; and

a catch-up preventing control logic circuit (9) controlled by the outputs from the two counters (1, 3) and acting on the inhibit input (13) of the first counter (1) in such a manner as to inhibit said first counter when it is in danger of catching up the second counter (3).

2. A circuit according to claim 1 having two counters of capacity not less than $2^N-1$ where N is an integer greater than 1, and characterized in that the catch-up preventing control logic circuit comprises first means for generating an inhibit instruction for the first counter when the first counter reaches 0 modulo $2^N$ while the second counter is in a count state lying in the range 0 to $2^{N-1}-1$ modulo $2^N$, and to remove this instruction only when the second counter reaches $2^{N-1}$ modulo $2^N$, and second means for generating an inhibit instruction for the first counter when the first counter reaches $2^{N-1}$ modulo $2^N$ while the second counter is in a count state lying in the range $2^{N-1}$ and $2^N-1$ modulo $2^N$, and for removing this instruction only when the second counter reaches 0 modulo $2^N$.

3. A circuit according to claim 2, characterized in that said first means comprise a first bistable (20) held in the rest state by a logic level 1 on the output of significance $2^{N-1}$ of the second counter (3) and triggered by a transition from logic level 1 to logic level 0 in the output of significance $2^{N-1}$ of the first counter (1), and in that said second means comprise a second bistable (21) held at rest by a logic level 0 on the output of significance $2^{N-1}$ of the second counter (3) and triggered by a transition from logic level 0 to logic level 1 in the output of significance $2^{N-1}$ of the first counter (1).

**Patentansprüche**

1. Einrichtung zur Stabilisierung des Takts, mit dem asynchrone Impulse auftreten, dadurch gekennzeichnet, daß sie folgende Komponenten aufweist:

- eine ersten asynchronen Impulszähler (1) mit einem Zähleingang (2), an dem die asynchronen Impulse ankommen, einem Sperreingang (13), parallelen Ausgängen und mit ersten Stufen, deren Betriebsgeschwindigkeit mit der maximalen Folgefrequenz der asynchronen Impulse kompatibel ist,
- einen Oszillator (5) mit einem Sperreingang (8), wobei der Oszillator am Ausgang taktstabilisierte Impulse liefert,
- einen zweiten Impulszähler (3) mit einem Zähleingang (4), an den die Ausgangsimpulse des Oszillators (5) angelegt werden, und mit parallelen Ausgängen,
- einen Komparator (6) mit Vergleichseingängen, die an Ausgänge gleicher Wertigkeit der beiden Zähler (1, 3) angeschlossen sind, und mit einem Gleichheitserfassungsausgang (7), der an den Sperreingang (8) des Oszillators angeschlossen ist, so daß der Komparator (6) den Oszillator (5) bei Gleichheit der Zählstände der beiden Zähler (1, 3) blockiert, und
- eine Einholverhinderungssteuerlogik (9), die durch Ausgänge der beiden Zähler (1, 3) gesteuert wird und auf den Sperreingang (13) des ersten Zählers (1) einwirkt, derart, daß dieser blockiert wird, wenn er Gefahr läuft, den zweiten Zähler (3) einzuholen.

2. Einrichtung nach Anspruch 1 mit zwei Zählern einer Kapazität von mindestens $2^N-1$ wobei N eine ganze Zahl größer als Eins ist, dadurch gekennzeichnet, daß die Einholverhinderungssteuerlogik folgende Komponenten aufweist: - erste Mittel zur Erzeugung eines Befehls zum Sperren des ersten Zählers, wenn dieser null modulo $2^N$ erreicht, während sich der zweite Zähler bei einem Zählerstand zwischen null und $2^{N-1}-1$ modulo $2^N$ befindet, wobei dieser Befehl erst aufgehoben wird, wenn der zweite Zähler den Wert $2^{N-1}$ modulo $2^N$ erreicht,

- und zweite Mittel zur Erzeugung eines Befehls zum Sperren des ersten Zählers, wenn dieser $2^{N-1}$ modulo $2^N$ erreicht, während sich der zweite Zähler bei einem Zählstand zwischen $2^{N-1}$ und $2^N-1$ modulo $2^N$ befindet, wobei dieser Befehl erst aufgehoben wird, wenn der zweite Zähler den Wert null modulo $2^N$ erreicht.

3. Einrichtung nach Anspruch 2, dadurch gekennzeichnet, daß die ersten Mittel eine erste Kippstufe (20) aufweisen, die durch Vorliegen eines Logikpegels 1 am Wertigkeitsausgang $2^{N-1}$ des zweiten Zählers (3) in Ruhestellung gehalten und durch einen Übergang vom Logikpegel 1 auf Logikpegel 0 am Wertigkeitsausgang $2^{N-1}$ des ersten Zählers (1) umgeschaltet wird, und daß die zweiten Mittel eine zweite Kippstufe (21) aufweisen, die durch Vorliegen eines Logikzustands 0 am Wertigkeitsausgang $2^{N-1}$ des zweiten Zählers in Ruhestellung gehalten und durch einen Übergang vom Logikpegel 0 auf Logikpegel 1 am Wertigkeitsausgang $2^{N-1}$ des ersten Zählers eingeschaltet wird.

# FIG.1

# FIG.2